Europäisches Patentamt

European Patent Office

Office européen des brevets

(19)

(11) EP 0 913 932 A2

(12) EUROPEAN PATENT APPLICATION

(43) Date of publication:
06.05.1999 Bulletin 1999/18

(51) Int Cl.$^6$: H03F 3/50

(21) Application number: 98308565.5

(22) Date of filing: 20.10.1998

(84) Designated Contracting States:
AT BE CH CY DE DK ES FI FR GB GR IE IT LI LU
MC NL PT SE
Designated Extension States:
AL LT LV MK RO SI

(30) Priority: 30.10.1997 US 960705

(71) Applicant: XEROX CORPORATION
Rochester, New York 14644 (US)

(72) Inventors:
• McIntyre, Harry J.
Los Angeles, California 90066-1000 (US)
• Yazdy, Mostafa R.
Los Angeles, California 90066 (US)

(74) Representative: Rackham, Stephen Neil
GILL JENNINGS & EVERY,
Broadgate House,
7 Eldon Street
London EC2M 7LH (GB)

(54) A buffering integrated circuit

(57) A buffering integrated circuit with a buffering means which receives a shifted down voltage at one of its inputs from a MOSFET. With the aid of a second MOSFET, the buffering means provides an output voltage which is substantially equal to its input voltage prior to level shift down.

FIG. 2

EP 0 913 932 A2

## Description

This invention relates generally to a buffering circuit and more particularly concerns a buffering integrated circuit with a buffer which receives a shifted down version of a voltage which requires to be buffered and outputs a voltage which is substantially equal to the original value of the voltage which needs to be buffered.

In an integrated circuit, if there is a need to buffer a voltage which is at a level outside the common mode voltage requirements of a buffer, it is typically level shifted down to match the input requirement of the buffer. Subsequently, the output voltage of the buffer has to be shifted substantially back to its original value and still be buffered.

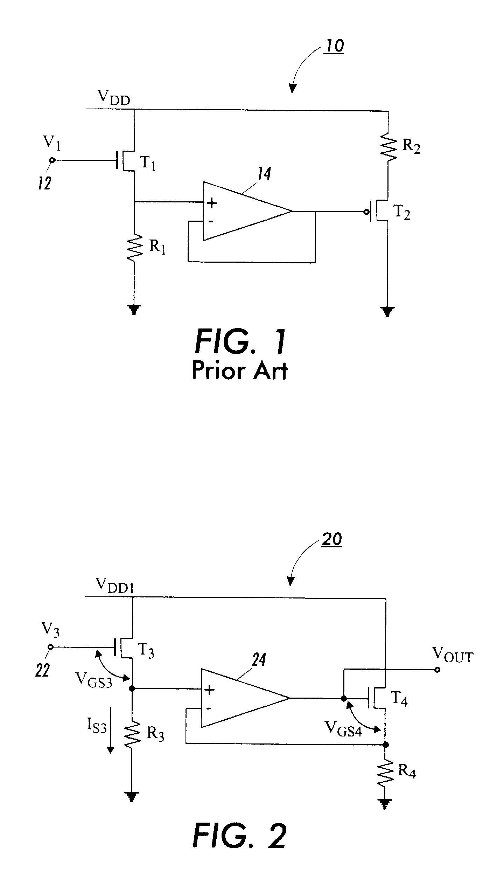

Referring to Figure 1, there is shown a prior art buffering circuit diagram 10 which shifts down a voltage prior to a buffer (Op-Amp) 14 and shifts it back up after buffer 14. In Figure 1, node 12 has a voltage $V_1$ which needs to be buffered. In order to match the input voltage requirement of the Op-Amp 14, voltage $V_1$ has to be shifted down. To shift down the voltage $V_1$, node 12 is connected to the gate of a Metal Oxide Semiconductor Field Effect Transistor (MOSFET) $T_1$. The drain of transistor $T_1$ is connected to a power supply $V_{DD}$ and its source is grounded through resistor $R_1$. Transistor $T_1$, which is a NMOS transistor, shifts down the voltage of its gate $v_{G1}$ to the source voltage $V_{S1}$ by the gate to source voltage $v_{GS1}$. Therefore, the source voltage $V_{S1}$ of the transistor $T_1$ is:

$$V_{S1} = V_{G1} - V_{GS1},$$

Since node 12 is connected to the gate of the transistor $T_1$, the source voltage is:

$$V_{S1} = V_1 - V_{GS1}.$$

As a result, transistor $T_1$ shifts down voltage $V_1$ by $V_{GS1}$ to $V_{S1}$.

The source of transistor $T_1$ is connected to the non-inverting input of Op-Amp 14. The inverting input of Op-Amp 14 is connected to its output which is connected to the gate of the transistor $T_2$. Op-Amp 14 delivers its non-inverting input to its output and therefrom to the gate of transistor $T_2$. In order to use the output voltage of the Op-Amp 14, it needs to be shifted back to the original value of $V_1$. Typically to shift back $V_{S1}$ to $V_1$, a PMOS transistor $T_2$ is used.

Since the transistor $T_2$ is a PMOS transistor, its source is connected to the power supply $V_{DD}$ through resistor $R_2$. Transistor $T_2$ has a gate to source voltage $V_{GS2}$. Therefore, the source voltage $V_{S2}$ of the transistor $T_2$ is:

$$V_{S2} = V_{G2} - V_{GS2},$$

where $V_{G2}$ is the gate voltage of transistor $T_2$ which is equal to the non-inverting input of Op-Amp 14. Therefore,

$$V_{G2} = V_1 - V_{GS1}.$$

As a result,

$$V_{S2} = V_1 - V_{GS1} - V_{GS2} = V_1 - V_{GS1} + |V_{GS2}|.$$

Where, $|V_{GS2}|$ is the absolute value of the $V_{GS2}$ which has a negative value for PMOS transistors.

Since transistor $T_1$ is a NMOS and transistor $T_2$ is a PMOS, even if the source current $I_{S1}$ of transistor T1 and the source current $I_{S2}$ of transistor T2 are kept the same, the gate to source voltages $V_{GS1}$ and $V_{GS2}$ are not exactly the same. This is due to the fact that transistors $T_1$ and $T_2$ are different type transistors and they do not have similar characteristics. Therefore, the source voltage $V_{S2}$ of the transistor $T_2$ which is the voltage that has been shifted up, is not exactly equal to $V_1$.

In accordance with the present invention, a buffering integrated circuit is disclosed which utilizes an Op-Amp and two MOSFETs for level shifting down and up. The source of the first MOSFET is connected to a first input of the Op-Amp and the source of the second MOSFET is connected to the second input of the Op-Amp and the output of the Op-Amp is connected to the gate of the second MOSFET. The first MOSFET receives a voltage and shifts it down and delivers it to the first input of the Op-Amp. The second MOSFET causes its gate and the output of the Op-Amp to be substantially equal to the received voltage by the first MOSFET.

Particular embodiments of buffering in accordance with this invention will now be described with reference to the accompanying drawings; in which:-

Figure 1 shows a circuit diagram of a prior art buffering circuit which shifts down a voltage prior to the buffer and shifts it back up after the buffer;
Figure 2 shows a circuit diagram of the buffering circuit of this invention;
Figure 3 shows an alternative buffering circuit of this invention; and
Figure 4 shows a circuit diagram of a buffering circuit of this invention with an opposite function to the function of circuit shown in Figure 2.

Referring to Figure 2, there is shown a buffering integrated circuit diagram 20 of this invention. In Figure 2, node 22 has a voltage $V_3$ which needs to be buffered. Voltage $V_3$ is shifted down to match the input voltage of an Op-Amp 24. In order to shift down the voltage $V_3$, node 22 is connected to the gate of MOSFET $T_3$ which is used as a level shifter. The drain of transistor $T_3$ is connected to a power supply $V_{DD1}$ and its source is connected to ground through resistor $R_3$. Transistor $T_3$ shifts down the voltage of its gate $V_{G3}$ to the source voltage $V_{S3}$ by the gate to source voltage $V_{GS3}$. Therefore, the source voltage $V_{S3}$ of the transistor $T_3$ is:

$$V_{S3} = V_{G3} - V_{GS3},$$

Since node 22 is connected to the gate of the transistor $T_3$, the source voltage is:

$$V_{S3} = V_3 - V_{GS3}.$$

As a result, transistor $T_3$ shifts down voltage $V_3$ by $V_{GS3}$ to $V_{S3}$. For the purpose of discussion, $V_{S3}$ is also called $V_{3(shifted\,down)}$

The source of transistor $T_3$ is connected to non-inverting input of Op-Amp 24. The output of Op-Amp 24 is connected to the gate of the transistor $T_4$. The drain of transistor $T_4$ is connected to the power supply $V_{DD1}$ and the source of transistor $T_4$ is grounded through a resistor R4.

It should be noted that in circuit 20, resistors $R_3$ and $R_4$ are selected in such a manner that the source current $I_{S3}$ of transistor $T_3$ and the source current $I_{S4}$ of transistor $T_4$ are equal.

Op-Amp 24 delivers its non-inverting input to its output and therefrom to the gate of transistor $T_4$. In order to use the output voltage of the Op-Amp 24, its output voltage needs to be shifted back to the original value of $V_3$. In this invention, in order to shift back the voltage $V_{3(shifted\,down)}$ to voltage $V_3$, a NMOS transistor $T_4$ is used.

The inverting input of Op-Amp 24 is connected to the source of transistor $T_4$ which causes the source voltage $S_4$ of transistor $T_4$ to be equal to the inverting and non-inverting inputs of the Op-Amp 24. It should be noted that in this configuration, the inverting and non-inverting inputs of the Op-Amp 24 are equal. Therefore, the source voltage $V_{S4}$ of the transistor $T_4$ is set to be equal to the source voltage $V_{S3}$ of transistor $T_3$. This causes the gate voltage $V_{G4}$ of transistor $T_4$ which is the output voltage of the Op-Amp 24 to be equal to:

$$V_{G4} = V_{S4} + V_{GS4},$$

where $V_{GS4}$ is the gate to source voltage of transistor $T_4$.

In this invention, transistor $T_4$ is used to guide the output of Op-Amp 24 to be shifted up. Both transistors $T_3$ and $T_4$ are NMOS transistors and they both are made with the same process and in the layout they are placed close to each other to minimize the process variation of different locations on the wafer. As a result, the gate to source voltages (threshold voltages) $V_{GS3}$ and $V_{GS4}$ of the two transistors $T_3$ and $T_4$ are substantially the same since the transistors $T_3$ and $T_4$ have identical sizes and currents. Therefore, since

$$V_{S3} = V_{3(shifted\,down)} = V_3 - V_{GS3},$$

and since

$$V_{G4} = V_{S4} + V_{GS4},$$

3

$$V_{S3} = V_{S4} \text{ (source voltage of } T_4 \text{ is set by Op-Amp 24 to be equal to source voltage of } T_3)$$

and

$$V_{GS3} = V_{GS4} \text{ (two identical transistors } T_3 \text{ and } T_4 \text{ have same currents)}$$

then

$$V_{OUT} = V_{G4} = V_{S3} + V_{GS4} = V_3 - V_{GS3} + V_{GS4} = V_3$$

Therefore, the output voltage Vout of Op-Amp 24 which is the gate voltage of the transistor $T_4$ is substantially equal to the voltage $V_3$ of node 22 and is a buffered output.

Furthermore, against the commonly accepted method of obtaining the level shifted output voltage from the source of transistor $T_4$, the output is obtained from the gate of transistor T4 which is also the output of the Op-Amp 24 and is buffered by the Op-Amp 24.

It should be noted that by selecting a different value for resistor $R_4$, the output voltage $V_{OUT}$ can be modified. This can be used in such applications which may require a voltage higher than the inverting or non-inverting input voltages of the Op-Amp 24 but not equal to the voltage $V_3$ of node 22.

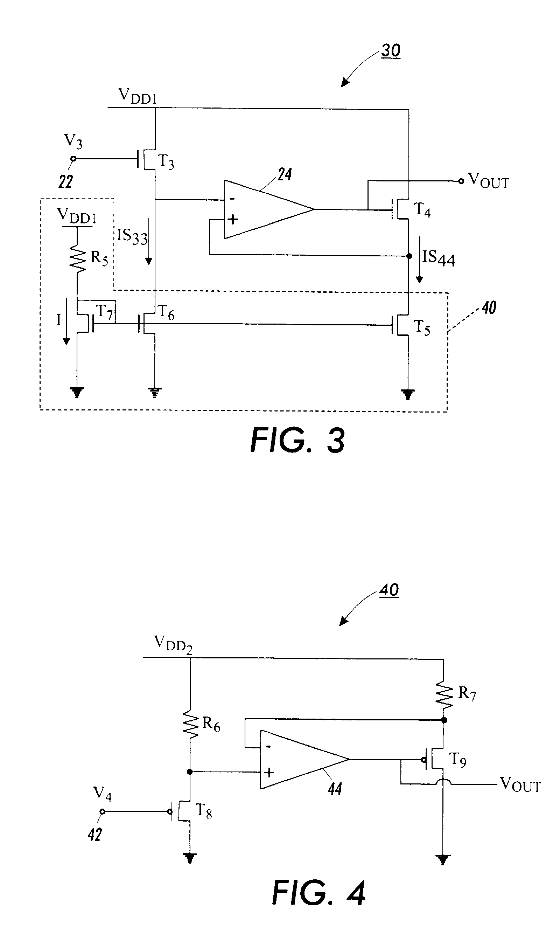

Referring to Figure 3, there is shown an alternative circuit 30 of this invention which is the same as circuit 20 of Figure 2 except the passive loads $R_3$ and $R_4$ of Figure 2 are replaced by a current mirror 40. All the elements of circuit 30 which are the same as the elements of circuit 20 are designated the same reference numerals. The current mirror 40 comprises three NMOS transistors $T_5$, $T_6$, and $T_7$. The sources of transistors $T_5$, $T_6$ and $T_7$ are all grounded and the gates of transistors $T_5$, $T_6$ and $T_7$ are connected to each other. The drain of transistor $T_5$ is connected to the source of transistor $T_4$ and the drain of transistor $T_6$ is connected to the source of transistor $T_3$. The drain of transistor $T_7$ is connected to its gate and also to the power supply $V_{DD1}$ through resistor $R_5$.

Transistor $T_7$ generates a current I and transistors $T_5$ and $T_6$ force the currents $I_{S33}$ and $I_{S44}$ to be identical to the current I. Therefore, the source current $I_{S33}$ of transistor $T_3$ and the source current $I_{S44}$ of transistor $T_4$ are identical.

The disclosed embodiments of this invention shift down a voltage which needs to be buffered and shift it up substantially to its original value.

The above buffering techniques can also be applied a voltage which is at a level below the common mode voltage requirement of a buffer. Referring to Figure 4, there is shown a buffering integrated circuit diagram 40 of this invention which shifts up voltage $V_4$ to match the requirements of Op-Amp 44 and subsequently shifts down the shifted up voltage back to its original value. In Figure 4, transistor $T_8$ shifts up the voltage $V_4$ and transistor $T_9$ causes the voltage $V_{OUT2}$ of its gate and the output of Op-Amp 44 to be substantially equal to $V_4$. It should be noted that transistors $T_8$ and $T_9$ are PMOS transistors.

It should be noted that by selecting a different value for resistor $R_7$, the output voltage $V_{OUT2}$ can be modified. This can be used in such applications that may require a voltage lower than the inverting or non-inverting input voltages of the Op-Amp 24 but not equal to the voltage $V_4$ of node 42.

**Claims**

1.   A buffering integrated circuit comprising:

   a first level shifting means having an input and an output;
   a buffering means having an input and an output;
   said input of said buffering means having a certain voltage level requirement;
   said output of said first level shifting means being electrically connected to said input of said buffering means;
   a second level shifting means having an input;
   said output of said buffering means being electrically connected to said input of said second level shifting means;
   said first level shifting means receiving a voltage through said input of said first level shifting means and shifting the received voltage up or down to match the certain voltage level requirement of said input of said buffering means; and

said second level shifting means being so constructed and arranged to cause a voltage at said input of said second level shifting means and said ouput of said buffering means to be higher or lower respectively, than a voltage at said input of said buffering means.

2.  A buffering integrated circuit as recited in claim 1, wherein the voltage at said input of said second level shifting means and a voltage at said ouput of said buffering means are substantially equal to the received voltage by said input of said first level shifting means.

3.  A buffering integrated circuit as recited in claim 1 or 2, wherein said first level shifting means is a NMOS transistor.

4.  A buffering integrated circuit as recited in claim 1, 2 or 3, wherein said second level shifting means is a NMOS transistor.

5.  A buffering integrated circuit comprising:

    a first MOSFET having a gate, a drain and a source;
    an Op-Amp having a first input, a second input and an output;
    said first and said second inputs of said Op-Amp having a certain voltage level requirement;
    said source of said first MOSFET being electrically connected to said first input of said Op-Amp;
    a second MOSFET having a gate, a drain and a source;
    said output of said Op-Amp being electrically connected to said gate of said second MOSFET;
    said drain of said first MOSFET and said drain of said second MOSFET being electrically connected to a power supply or grounded;
    current means being electrically connected to said source of said MOSFET and to said source of said second MOSFET for providing substantially equal currents to both said first MOSFET and said second MOSFET;
    said first MOSFET receiving a voltage through said gate of said first MOSFET, shifting down or up respectively the received voltage to match the certain voltage level requirement of said first and said second inputs of said Op-Amp and delivering the shifted voltage to said first input of said Op-Amp through said source of said first MOSFET; and
    said second input of said Op-Amp being electrically connected to said source of said second MOSFET to cause a voltage at said gate of said second MOSFET and a voltage at said ouput of said Op-Amp to be substantially equal to the received voltage by said gate of said first MOSFET.

6.  A buffering integrated circuit as recited in claim 5, wherein said current means is a current mirror.

7.  A buffering integrated circuit as recited in claim 5 or 6, wherein said first input of said Op-Amp is the non-inverting input of the Op-Amp.

## FIG. 1
Prior Art

## FIG. 2

FIG. 3

FIG. 4